# EUROPEAN PATENT APPLICATION

(11) **EP 4 503 104 A1**
(43) Date of publication of application: **05.02.2025**
(21) Application number: 23780582.5
(22) Date of filing: 28.03.2023
(51) Int. Cl.: H01L 21/52, B22F 7/08, B22F 9/00

(54) **METHOD FOR MANUFACTURING BONDED BODY AND METHOD FOR BONDING BODIES TO BE BONDED**

(30) Priority: 30.03.2022 JP 2022056552
(71) Applicant: Mitsui Mining & Smelting Co., Ltd., Shinagawa-ku Tokyo 141-8584 (JP)
(72) Inventor: HATTORI, Takashi, Ageo-shi, Saitama 362-0021 (JP); YAMAUCHI, Shinichi, Ageo-shi, Saitama 362-0021 (JP); ANAI, Kei, Ageo-shi, Saitama 362-0021 (JP)
(74) Representative: Novagraaf Technologies
(86) International application number: PCT/JP2023/012630
(87) International publication number: WO 2023/190573

(57) **Abstract**

A joined body in which a first joining target (11) and a second joining target (13) are joined with a joining layer interposed therebetween is produced. A paste that contains copper particles and an organic solvent is applied to the first joining target (11) to form a coating film (12X). The second joining target (13) is placed on the coating film (12X) to form a stack (15). The stack (15) is heated and pressed to sinter the copper particles contained in the coating film (12X) to form a joining layer. The heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.

## Description

### Technical Field

The present invention relates to a method for manufacturing bonded body and a method for bonding bodies to be bonded.

### Background Art

In recent years, semiconductor devices called "power devices" such as IGBT have been widely used as power conversion and control devices such as inverters. In order to produce semiconductor devices as described above, various methods have been proposed in which a metal paste is used as means for joining a semiconductor element to a circuit substrate or the like.

For example, Patent Literature 1 discloses a method for producing a semiconductor device that includes a highly reliable sintered joint portion and in which damage to a semiconductor element caused by pressing is suppressed. Patent Literature 1 also discloses that sinterable metal particles that are formed into the sintered joint portion are heated and pressed at a predetermined timing.

### Citation List

### Patent Literature

Patent Literature 1: JP 2018-110149A

### Summary of Invention

According to the technique described above, a high pressure is applied to the semiconductor element when reaching a sintering start temperature. For this reason, the technique described above is problematic in that cracks are formed at corners of an end region (hereinafter, also referred to as a "fillet portion") of the sintered joint portion where the semiconductor element is not placed when the sintered joint portion is viewed in a plan view.

Accordingly, it is an object of the present invention to provide a method for producing a joined body, wherein it is possible to suppress cracks formed in the fillet portion.

The present invention provides a method for producing a joined body in which a first joining target and a second joining target are joined with a joining layer interposed between the first joining target and the second joining target,
the production method comprising:
   a step of applying a paste that contains copper particles and an organic solvent to the first joining target to form a coating film;
   a step of placing the second joining target on the coating film to form a stack; and
   a sintering step of heating and pressing the stack to sinter the copper particles contained in the coating film to form the joining layer,
wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.

Furthermore, the present invention provides a method for joining a first joining target and a second joining target with a joining layer interposed between the first joining target and the second joining target,
the method comprising:
   a step of applying a paste that contains copper particles and an organic solvent to the first joining target to form a coating film;
   a step of placing the second joining target on the coating film to form a stack; and
   a sintering step of heating and pressing the stack to sinter the copper particles contained in the coating film to form the joining layer,
wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.

### Brief Description of Drawings

[Fig. 1] Fig. 1 is a schematic diagram showing a first step of a method for producing a joined body according to the present invention.
[Fig. 2] Fig. 2 is a schematic diagram showing a step performed subsequent to the step shown in Fig. 1.
[Fig. 3] Fig. 3 is a schematic diagram showing cracks that have appeared in a fillet portion of the joined body.

### Description of Embodiments

Hereinafter, a method for producing a joined body and a method for producing joining targets according to the present invention will be described by way of preferred embodiments thereof. A jointed body produced based on the method of the present invention has a structure in which a first joining target and a second joining target are joined with a joining layer interposed therebetween. As will be described later, the joining layer is composed of a sintered body obtained by sintering a paste that contains copper particles and an organic solvent.

There is no particular limitation on the type of first joining target. In general, it is preferable that, the first joining target contains a metal in a surface to be joined. For example, as the first joining target, it is possible to use a member that has a metal surface that is made of a metal. Here, the term "metal " used in the specification of the present application refers to a metal that is not combined with another element to form a compound, or an alloy composed of two or more metals. Examples of the metal include copper, silver, gold, aluminum, palladium, nickel, and an alloy composed of a combination of two or more thereof.

In the case where the first joining target is a member that has a metal surface, the metal surface may be made of one metal or two or more metals. In the case where the metal surface is made of two or more metals, the metal surface may be made of an alloy. In general, it is preferable that the metal surface is planar, but the metal surface may be curved in some cases.

Specific examples of the first joining target include: a spacer, a heat dissipation plate, and a semiconductor element that are made of any of the metals listed above; a substrate that contains at least one of the metals listed above on a surface thereof; and the like.

Examples of the substrate include: an insulating substrate that includes a metal layer made of copper or the like on a surface of a ceramic or aluminum nitride plate; and the like.

In the case where a semiconductor element is used as the joining target, the semiconductor element can contain one or more of elements of Si, Ga, Ge, C, N, and As.

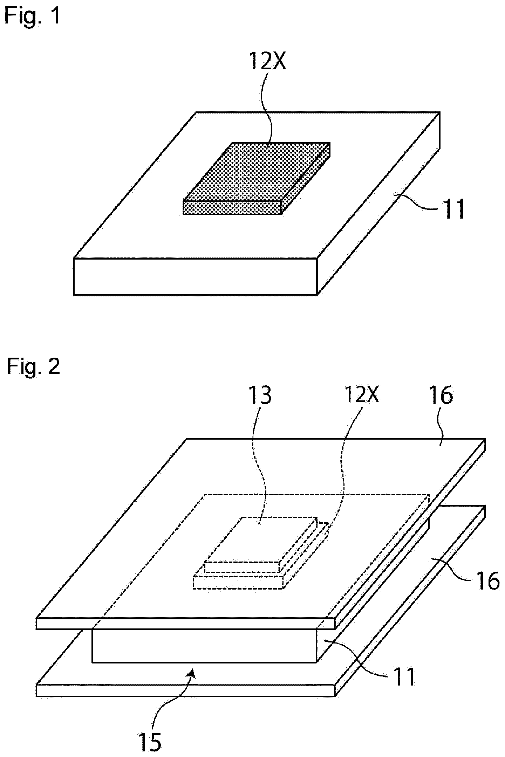

Figs. 1 and 2 are process diagrams illustrating a method for joining a joined body according to the present invention. In the production method, as shown in Fig. 1, a paste that contains copper particles is first applied onto a first joining target 11 to form a coating film 12X. There is no particular limitation on the method for applying the paste. It is possible to use, for example, a screen printing method, a gravure printing method, a dispense printing method, a reverse coating method, or a doctor blade method.

The paste used in the present invention contains copper particles and an organic solvent, which will be described later, and may optionally contain adjusting agents, which will be described later, as appropriate.

The copper particles contained in the paste encompass both particles of pure copper and particles of a copper-based alloy. The copper particles contained in the paste may be composed only of particles of pure copper or particles of a copper-based alloy, or may be composed of a mixture of particles of pure copper and particles of a copper-based alloy.

It is permitted that the paste contains a small amount of metal particles other than copper particles as long as the advantageous effects of the present invention are not impaired.

There is no particular limitation on the shape of the copper particles contained in the paste, and the copper particles may have a spherical shape or a non-spherical shape.

Here, the expression "copper particles have a spherical shape" means that the copper particles have a circularity coefficient of 0.85 or more determined through measurement using the following method. The circularity coefficient is calculated based on the following method. Specifically, a scanning electron microscope image of a copper particle that is a primary particle is captured, and the circularity coefficient of the copper particle is calculated based on the equation: 4π S/L², where S represents the area of the two-dimensional projection image of the copper particle, and L represents the perimeter length of the copper particle.

On the other hand, the expression "copper particles have a non-spherical shape" means that the copper particles have a circularity coefficient of less than 0.85 determined through measurement using the above-described method.

Specific examples of the non-spherical shape include a flat shape, a polyhedral shape such as a hexahedral shape and an octahedral shape, a fusiform shape, and an irregular shape. In the present invention, it is preferable that one of two or more types of copper powders are flat copper particles. As will be described later, it is more preferable that the paste contains flat copper particles and spherical copper particles.

In the present invention, the term "flat shape" refers to a shape that includes a pair of plate surfaces that form main surfaces of a particle and a side surface that is perpendicular to the plate surfaces. The plate surfaces and the side surface may be each independently a flat surface, a curved surface, or a rough surface.

In the case of spherical copper particles, the particle size is determined based on the following method. Specifically, 50 or more copper particles that are primary particles with clear outlines are selected from a scanning electron microscope image of copper particles captured at a magnitude of 10,000 times or more and 150,000 times or less, and then, the Haywood diameter of each particle is measured. Next, based on the obtained Haywood diameter, the volume of the particle is calculated assuming that the particle is a true sphere, and then, a volume-based cumulative particle size at 50% cumulative volume of the obtained volume is determined as D_{SEM50}.

The particle size D_{SEM50} of the copper particles is preferably greater than 0.1 µm, more preferably 0.11 µm or more, and even more preferably 0.12 µm or more. On the other hand, the particle size D_{SEM50} is preferably 0.55 µm or less, and more preferably 0.5 µm or less. By setting the particle size D_{SEM50} to a value greater than 0.1 µm, cracking due to contraction is unlikely to occur when the coating film 12X formed by applying the paste is sintered to form a joining layer, and thus a sufficient joining strength between the fillet portion of the joining layer and the first joining target 11 can be obtained. On the other hand, by setting the particle size D_{SEM50} to a value less than or equal to 0.55 µm, the copper particles that are present in the coating film 12X can be sufficiently sintered.

In the case of non-spherical copper particles, the particle size is determined as a volume-based cumulative particle size D₅₀ at 50% cumulative volume obtained based on a laser diffraction scattering particle size distribution measurement method. For example, the particle size can be determined based on the following method. Specifically, 0.1 g of measurement sample is mixed with an aqueous dispersant solution, and dispersed for one minute using an ultrasonic homogenizer (US-300T available from Nihonseiki Kaisha, Ltd.). After that, a particle size distribution is determined using, for example, a laser diffraction scattering particle size distribution measurement apparatus MT3300 EXII available from Microtrac BEL Corporation. In this way, the particle size D₅₀ is calculated.

The particle size D₅₀ of the copper particles is preferably 0.3 µm or more and 50 µm or less, more preferably 0.5 µm or more and 40 µm or less, and even more preferably 1 µm or more and 20 µm or less. When the particle size D₅₀ is within the above-described range, a densely sintered joining layer can be easily obtained by sintering the copper paste formed into a coating film, and it is possible to achieve a high joining strength between the joining targets and an improvement in conductive reliability.

The copper particles can be produced based on various methods known in the pertinent technical field. For example, copper powder can be produced based on a wet-reduction method, an atomizing method, an electrolysis method, or the like. The method can be selected as appropriate according to the particle size, the shape, or the like of the copper particles. The paste may be prepared using only copper particles of any one of the shapes listed above, or a combination of copper particles of two or more of the shapes listed above. Alternatively, it is also possible to use a mixture of copper particles that have a predetermined average particle size and copper particles that have an average particle size different from the predetermined average particle size.

In particular, when the paste contains spherical copper particles (first copper particles) that have a particle size D_{SEM50} of greater than 0.1 µm and 0.55 µm or less and non-spherical copper particles (second copper particles) that have a particle size D₅₀ of 0.3 µm or more and 50 µm or less, it is possible to form a coating film that has excellent sinterability while preventing cracking in the coating film caused by an excessive volume contraction of the coating film. From the viewpoint of making this advantageous effect even more remarkable, the proportion of the first copper particles relative to the total mass of the first copper particles and the second copper particles is preferably 20 mass% or more and 95 mass% or less, more preferably 25 mass% or more and 90 mass% or less, and even more preferably 30 mass% or more and 85 mass% or less. In particular, it is preferable that the first copper particles have a spherical shape and the second copper particles have a flat shape because the resulting sintered body is more dense.

The surfaces of the copper particles may be treated with an organic surface treatment agent. The organic surface treatment agent is an agent for suppressing aggregation between copper particles. Examples of the agent for suppressing aggregation between copper particles preferably used in the present invention include various types of fatty acids, aliphatic amines, and a complexing agent that has an affinity for copper. In particular, from the viewpoint of improving oxidation resistance, it is preferable to use a saturated or unsaturated fatty acid or aliphatic amine that has 6 or more and 18 or less carbon atoms, especially, 10 or more and 18 or less carbon atoms. Specific examples of the fatty acid and the aliphatic amine include benzoic acid, pentanoic acid, hexanoic acid, octanoic acid, nonanoic acid, decanoic acid, lauric acid, palmitic acid, oleic acid, stearic acid, pentylamine, hexylamine, octylamine, decylamine, laurylamine, oleylamine, stearylamine, and the like. Examples of the complexing agent that has an affinity for copper include amino acids such as glycine, dimethylglyoxime, and the like. The fatty acids, the aliphatic amines, and the complexing agents listed above may be used alone or in a combination of two or more.

From the viewpoint of enhancing the packability of the copper particles and maintaining a sufficient joining strength of the joining layer, the amount of the copper particles contained in the paste is preferably 50 mass% or more, and more preferably 60 mass% or more and 95 mass% or less.

The coating film 12X has a thickness of preferably 1 µm or more and 300 µm or less, and more preferably 5 µm or more and 250 µm or less, in such a manner that a joining layer formed from the coating film can have a sufficient joining strength.

As the organic solvent contained in the paste, any conventionally known organic solvent can be used without a particular limitation. Examples of the organic solvent include a monohydric alcohol, a polyhydric alcohol, a polyhydric alcohol alkyl ether, a polyhydric alcohol aryl ether, an aliphatic organic acid, an ester, a nitrogen-containing heterocyclic compound, an amide, an amine, a saturated hydrocarbon, and the like. These organic solvents may be used alone or in a combination of two or more.

There is no particular limitation on the amount of the organic solvent contained in the paste as long as the paste can have a viscosity required to form a coating film. In general, the amount of the organic solvent is preferably 5 mass% or more and 50 mass% or less relative to the amount of the paste.

The paste may contain adjusting agents for adjusting various types of properties as appropriate. Examples of the adjusting agents include a reducing agent, a viscosity adjusting agent, and a surface tension adjusting agent.

As the reducing agent, it is possible to use a reducing agent that can facilitate the sintering of the copper particles. Examples of the reducing agent include a monohydric alcohol, a polyhydric alcohol, an amino alcohol, citric acid, oxalic acid, formic acid, ascorbic acid, aldehyde, hydrazine, derivatives thereof, hydroxylamine, derivatives thereof, dithiothreitol, phosphite, hydrophosphite, phosphorous acid, derivatives thereof, and the like.

As the viscosity adjusting agent, it is possible to use a viscosity adjusting agent that can adjust the variation in viscosity of the paste and can preferably set the viscosity of the paste within the above-described range. Examples of the viscosity adjusting agent include a ketone, an ester, an alcohol, a glycol, a hydrocarbon, a polymer, and the like.

As the surface tension adjusting agent, it is possible to use a surface tension adjusting agent that can adjust the surface tension of the coating film 12X. Examples of the surface tension adjusting agent include an acrylic surfactant, a silicone-based surfactant, an alkyl polyoxyethylene ether, a polymer such as a fatty acid glycerol ester, an alcohol-based surfactant, a hydrocarbon-based surfactant, an ester-based surfactant, and a monomer such as glycol.

The viscosity of the paste can be measured using a rheometer MARS III available from Thermo Scientific, Inc. From the viewpoint of enhancing ease of application and ease of printing of the copper paste, the viscosity of the paste when the shear rate is 10 s⁻¹ is preferably 10 Pa•s or more and 200 Pa•s or less, and more preferably 15 Pa•s or more and 200 Pa•s or less. Measurement conditions for measuring the viscosity of the copper paste are shown below.
Measurement mode: shear rate dependency measurement
Sensor: parallel type (Φ 20 mm)
Measurement temperature: 25°C
Gap: 0.300 mm
Shear rate: 0.05 to 120.01 s⁻¹
Measurement time: 2 minutes

The dimensions and the shape of the coating film 12X formed on the first joining target 11 may be the same as the dimensions and the shape of a second joining target 13, which will be described later. Alternatively, the coating film 12X may have such dimensions that the coating film 12X extends from the peripheral edges of the second joining target 13 when the second joining target 13 is placed on the coating film 12X. In the case of the latter, the first joining target 11 and the second joining target 13 are reliably joined by the joining layer. Accordingly, the latter configuration is preferable. In this case, the coating film 12X includes an extension portion, or in other words, a fillet portion, that extends from the peripheral edges of the second joining target 13.

After the coating film 12X has been formed on a surface of the first joining target 11, as shown in Fig. 2, a second joining target 13 is placed on the coating film 12X to form a stack 15 in which the first joining target 11, the coating film 12X, and the second joining target 13 are stacked in this order. As the second joining target 13, any of the examples of the first joining target 11 listed above can be used without a particular limitation. In the case where the first joining target 11 is, for example, a substrate, the second joining target 13 is preferably, for example, any one of a spacer, a heat dissipation plate, and a semiconductor element.

In the case where the second joining target 13 is placed on the coating film 12X, the concentration of organic solvent contained in the coating film 12X may be substantially the same as or lower than the concentration of the organic solvent contained in the paste. In the case of the latter, the organic solvent can be removed by, after the coating film 12X has been formed on the first joining target 11, natural drying the coating film 12X by leaving the coating film 12X for a predetermined length of time, or by heat drying the coating film 12X.

Next, as shown in Fig. 2, a sintering step of holding the stack 15 between predetermined plate-shaped jigs 16, and then heating the stack 15 and pressing the stack 15 with the jigs 16 is performed. As the heating proceeds, the organic solvent is removed from the coating film 12X, and sintering of the copper particles contained in the coating film 12X starts. As the pressing apparatus that includes plate-shaped jigs 16, any conventionally known pressing apparatus can be used without a particular limitation.

The heating and the pressing may be started at the same time. Alternatively, the heating may be started first, and after a predetermined length of time passes, the pressing may be started. Conversely, the pressing may be started first, and after a predetermined length of time passes, the heating may be started.

In the sintering step, by controlling heating and pressing profiles, a joining layer composed of a sintered body of the copper particles can be conveniently formed. In particular, in the case where the joining layer includes a fillet portion, it is possible to suppress cracks formed in the fillet portion. Specifically, in the sintering step, the heating is performed incrementally from the heating start temperature to the highest temperature Tm. In addition thereto, the pressing is performed incrementally from the pressing start pressure to the highest pressure Pm.

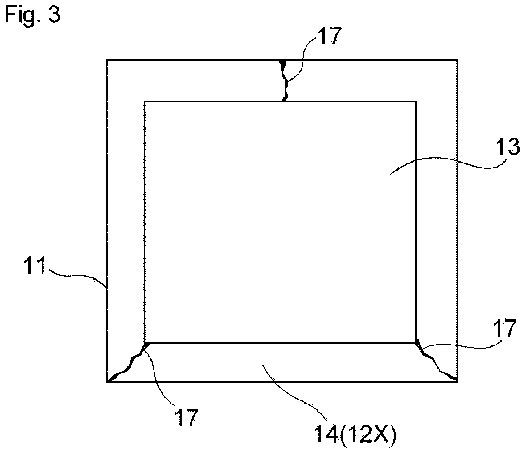

In the present invention, the cracks formed in the fillet portion include not only a crack 17 formed at a corner of the fillet portion 14, but also a crack 17 formed near the center of a side of the fillet portion 14 as shown in Fig. 3, and also include, although not shown in the diagram, a crack that does not extend from the end portion of the second joining target 13 to the outer periphery of the fillet portion 14, or in other words, a crack formed within the fillet portion.

Also, in the specification of the present application, the expression "heating is performed incrementally" means that heating is performed in such a manner that there is no period during which the temperature decreases along with time from the time when the heating in the sintering step starts to when the heating temperature reaches highest temperature Tm. Accordingly, in the sintering step, a period during which the heating temperature is constant is permitted. For example, the heating in the sintering step may be performed in any one of the following manners: the temperature increases linearly along with time; the temperature increases exponentially; the temperature increases logarithmically; the temperature increases stepwise; and the temperature increases so as to form a temperature increase line of a combination thereof.

Also, in the specification of the present application, the expression "pressing is performed incrementally" means that pressing is performed in such a manner that there is no period during which the pressure decreases along with time from the time when the pressing in the sintering step starts to when the pressing pressure reaches the highest pressure Pm. Accordingly, in the sintering step, a period during which the pressure is constant is permitted. For example, the pressing in the sintering step may be performed in any one of the following manners: the pressure increases linearly along with time; the pressure increases exponentially; the pressure increases logarithmically, the pressure increases stepwise; and the pressure increases so as to form a pressure increase line of a combination thereof.

In the sintering step, in addition to incrementally performing the heating and the pressing, heating and pressing conditions are controlled in such a manner that the pressing pressure is 15 MPa or less when the heating temperature reaches 200°C. By controlling the heating and pressing profiles as described above, it is possible to effectively suppress cracks formed in the fillet portion. The reason is described below.

It is advantageous to incrementally heat and press the stack 15 from the viewpoint of improving the production efficiency of the intended joined body. Under the above-described condition, by controlling the heating and pressing conditions in such a manner that the pressing pressure is 15 MPa or less when the heating temperature reaches 200°C, in the coating film 12X, a portion that is located directly below the second joining target 13 (hereinafter, the portion will also be referred to as a "die-directly-below portion") and an extension portion that extends from the peripheral edges of the second joining target 13, or in other words, a fillet portion, contract to substantially the same extent. As a result, cracks formed in the fillet portion 14 is suppressed.

In contrast, when sintering of the copper particles starts while the pressing is proceeding, a contraction difference occurs between the die-directly-below portion and the extension portion that extends from the peripheral edges of the second joining target 13, or in other words, the fillet portion 14. Accordingly, cracks are likely to be formed in the fillet portion 14, in particular, at the corners of the fillet portion 14.

From the viewpoint of making the above-described advantageous effect even more remarkable, the pressing pressure is preferably 15 MPa or less, more preferably 13 MPa or less when the heating temperature reaches 200°C. From the viewpoint of suppressing cracks, the lower the pressing pressure, the more preferable. The pressing may be started after the heating temperature reaches 200°C.

The reason that, as a reference temperature, a temperature of 200°C is set to control the pressing pressure is that, because it is assumed that the sintering temperature of the copper particles is usually about 250°C, sintering of the copper particles does not start at 200°C, and thus contraction of the coating film 12X can be controlled.

In the sintering step, as long as the pressing pressure is 15 MPa or less when the heating temperature reaches 200°C, control may be performed in such a manner that the pressing pressure reaches the highest pressure Pm after the heating temperature reaches the highest temperature Tm, or conversely, in such a manner that the heating temperature reaches the highest temperature Tm after the pressing pressure reaches the highest pressure Pm. Alternatively, the heating and the pressing may be controlled in such a manner that the highest temperature Tm and the highest pressure Pm are simultaneously reached. From the viewpoint of more effectively exhibiting the advantageous effect of suppressing cracks formed in the fillet, control is preferably performed in such a manner that the pressing pressure reaches the highest pressure Pm after the heating temperature reaches the highest temperature Tm.

The heating in the sintering step may be performed in any one of the following manners as long as it is performed incrementally: the temperature increases linearly along with time; the temperature increases exponentially; the temperature increases logarithmically; the temperature increases stepwise; or the temperature increases so as to form a temperature increase line of a combination thereof. The same applies to the pressing in the sintering step.

Irrespective of any of the heating manners described above, from the viewpoint of efficiently producing the joined body, it is preferable that the sintering step does not include a constant temperature process in which a temperature is kept constant for 10 seconds or more, in particular, for 5 seconds or more from the heating start temperature to the highest temperature Tm. For the same reason, it is preferable that the sintering step does not include a constant pressure process in which a pressure is kept constant for 10 seconds or more, in particular, for 5 seconds or more from the pressing start pressure to the highest pressure Pm. In the case where the sintering step includes both the constant temperature process and the constant pressure process, a period for the constant temperature process and a period for the constant pressure process can be each independently set, and the two processes do not necessarily need to be synchronized.

From the viewpoint of efficiently producing the joined body, when heating the stack in the sintering step, the time required for the temperature to reach the highest temperature Tm from the heating start temperature is 1 second or more and 30 minutes or less, preferably 1 second or more and 10 minutes or less, and more preferably 1 second or more and 1 minute or less.

From the viewpoint of allowing the coating film 12X to contract to substantially the same extent to the die-directly-below portion and the fillet portion, the stack may be pressed in the sintering step at a pressure increase rate of preferably 0.2 MPa/s or more, or 1 MPa/s or more.

Also, the stack may be pressed in the sintering step at a pressure increase rate of preferably 20 MPa/s or less, more preferably 10 MPa/s or less, and even more preferably 5 MPa/s or less.

From the viewpoint of preventing the fillet portion from lifting, the pressure increase rate during the pressing is preferably 0.2 MPa/s or more and 10 MPa/s or less, and more preferably 0.2 MPa/s or more and 5 MPa/s or less.

In the calculation of the pressure increase rate, the constant pressure process is excluded.

In the case where the pressure increase rate is not constant until the pressing pressure reaches the highest pressure Pm, it is sufficient that the pressure increase rate is within the above-described range.

It is preferable that the highest temperature Tm during the heating in the sintering step is set to 200°C or more and 350°C or less from the viewpoint of not only sufficiently sintering the copper particles, but also preventing damage to the joining targets due to heat. From this viewpoint, highest temperature Tm is preferably 210°C or more and 330°C or less, and more preferably 220°C or more and 310°C or less.

From the same viewpoint as described above, the highest pressure Pm during the pressing in the sintering step is set to preferably 1 MPa or more and 40 MPa or less, more preferably 5 MPa or more and 40 MPa or less, and even more preferably 5 MPa or more and 30 MPa or less.

After the heating temperature reaches the highest temperature Tm, the heating temperature may be maintained at the highest temperature Tm, or decreased to a value lower than the highest temperature Tm. In either case, it is preferable that, when the heating temperature reaches the highest temperature Tm, the heating temperature is kept constant within a temperature range of (Tm - 30)°C or more and Tm°C or less, from the viewpoint of sufficiently sintering the copper particles.

Regarding the pressing, after the pressing pressure reaches the highest pressure Pm, the pressing pressure may be maintained at the highest pressure Pm, or decreased to a value lower than the highest pressure Pm. In either case, it is preferable that, when the pressing pressure reaches the highest pressure Pm, the heating temperature is kept constant within a temperature range of (Pm - 5) MPa or more and Pm MPa or less, from the viewpoint of sufficiently sintering the copper particles.

In the sintering step, for example, an inert atmosphere or an oxygen-containing atmosphere can be used. The inert atmosphere may be, for example, a nitrogen gas atmosphere, a noble gas atmosphere such as argon or neon, or the like. From the viewpoint of economic performance, it is preferable to use a nitrogen gas atmosphere. As the oxygen-containing atmosphere, for example, an air atmosphere can be used.

By subjecting the stack 15 to the sintering step, the coating film 12X included in the stack 15 is formed into a sintered body that serves as the joining layer, and the first joining target 11 and the second joining target 13 are joined with a high joining strength. Also, even in the case where the joining layer includes a fillet portion, cracks formed in the fillet portion are effectively suppressed, and thus the joined body has high reliability. Accordingly, the joined body obtained through the production method of the present invention is preferably used in a device that handles a large electric current, for example, an in-vehicle electronic circuit, an electronic circuit on which a power device is mounted, or the like.

The present invention has been described above based on a preferred embodiment thereof. However, the present invention is not limited to the embodiment given above.

Regarding the embodiment described above, the present invention further discloses a method for manufacturing bonded body and a method for bonding bodies to be bonded given below.
[1] A method for producing a joined body in which a first joining target and a second joining target are joined with a joining layer interposed between the first joining target and the second joining target,
   the production method comprising:
      a step of applying a paste that contains copper particles and an organic solvent to the first joining target to form a coating film;
      a step of placing the second joining target on the coating film to form a stack; and
      a sintering step of heating and pressing the stack to sinter the copper particles contained in the coating film to form the joining layer,
   wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.
[2] The method for producing a joined body as set forth in clause [1],
   wherein the coating film is applied in such a manner that the coating film has such dimensions that the coating film extends from peripheral edges of the second joining target when the second joining target is placed on the coating film.
[3] The method for producing a joined body as set forth in clause [1] or [2],
   wherein, in the sintering step, control is performed in such a manner that the pressing pressure reaches the highest pressure Pm after the heating temperature reaches the highest temperature Tm.
[4] The method as set forth in any one of clauses [1] to [3],
   wherein the sintering step does not include a constant temperature process for 10 seconds or more from the heating start temperature to the highest temperature Tm.
[5] The method for producing a joined body as set forth in any one of clauses [1] to [4],
   wherein the sintering step does not include a constant pressure process for 10 seconds or more from the pressing start pressure to the highest pressure Pm.
[6] The method for producing a joined body as set forth in any one of clauses [1] to [5],
   wherein the highest temperature Tm is 200°C or more and 350°C or less.
[7] The method for producing a joined body as set forth in clause [6],
   wherein, when the heating temperature reaches the highest temperature Tm, the heating temperature is kept constant within a range of (Tm - 30)°C or more and Tm°C or less.
[8] The method for producing a joined body as set forth in any one of clauses [1] to [7],
   wherein the highest pressure Pm is 1 MPa or more and 40 MPa or less.
[9] The method for producing a joined body as set forth in clause [8],
   wherein, when the pressing pressure reaches the highest pressure Pm, the pressing pressure is kept constant within a range of (Pm - 5) MPa or more and Pm MPa.
[10] A method for joining a first joining target and a second joining target with a joining layer interposed between the first joining target and the second joining target,
   the method comprising:
      a step of applying a paste that contains copper particles and an organic solvent to the first joining target to form a coating film;
      a step of placing the second joining target on the coating film to form a stack; and
      a sintering step of heating and pressing the stack to sinter the copper particles contained in the coating film to form the joining layer,
   wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.

### Examples

Hereinafter, the present invention will be described in further detail based on examples. However, the scope of the present invention is not limited to the examples given below. Unless otherwise stated, the percent sign "%" used herein means "mass%".

### Example 1

### (1) Preparation of Paste

A paste was prepared by mixing first copper particles (spherical copper particles with a particle size D_{SEM50} of 0.16 µm), second copper particles (flat copper particles with a particle size D₅₀ of 4.2 µm), hexylene glycol (an organic solvent), polyethylene glycol (an organic solvent with a molecular weight of 300), and bis(2-hydroxyethyl) iminotris (hydroxymethyl)methane (a reducing agent).

The total content of the first copper particles and the second copper particles in the paste was 82%, the content of the organic solvent was 17.9%, and the content of the reducing agent was 0.1%. The mass ratio between the first copper particles and the second copper particles (first copper particles: second copper particles) was 7:3.

### (2) Formation of Coating Film

The paste was applied onto a copper substrate through printing using a metal mask with a length of 6.0 mm, a width of 6.0 mm, and a thickness of 200 µm to form a rectangular coating film. The formed coating film was dried at 110°C in an air atmosphere for 20 minutes.

### (3) Formation of Stack

An Ag-plated alumina chip (with a length of 5 mm, a width of 5 mm, and a thickness of 0.5 mm) was prepared assuming it as a model member of a semiconductor power device. The alumina chip was placed on the dried coating film, with an Ag-plated surface of the alumina chip opposing the dried coating film, and then, a load of 0.8 Mpa was applied thereon for 2 seconds. In this way, a stack in which the first joining target, the coating film, and the second joining target were stacked in this order was formed.

### (4) Heating and Pressing of Stack

Heating and pressing of the stack were simultaneously started at an initial temperature of 40°C in an unloaded state (excluding the own weight). The time required for the temperature to reach 300°C from 40°C was 15 seconds. The temperature increase rate was 17.3°C/s on average, and the pressure increase rate was 1.3 MPa/s. The temperature and the pressure were increased linearly along with time. The atmosphere was a nitrogen gas atmosphere. The pressure was 8.7 MPa when the temperature reached 200°C. The temperature increase was stopped when the temperature reached 300°C that has been set as the highest temperature Tm. After that, the temperature was maintained at 300°C. When the temperature reached 300°C, the pressure also reached 20 MPa that has been set as the highest pressure Pm. After that, the pressure was maintained at 20 MPa. At 10 minutes after the highest temperature Tm and the highest pressure Pm were reached, the heating and the pressing were stopped, and the stack was then naturally cooled. In this way, an intended joined body was obtained.

### Comparative Example 1

In the section "(4) Heating and Pressing of Stack" in Example 1, the time required for the temperature to reach 300°C from 40°C was changed to 30 seconds. The temperature increase rate was changed to 8.7°C/s on average, and the pressure increase rate was changed to 1.3 MPa/s. The pressure increase was stopped when the pressure reached 20 MPa that has been set as the highest pressure Pm. After that, the pressure was maintained at the highest pressure Pm. At this time, the temperature was continuously increased. The pressure was 20 MPa when the temperature reached 200°C. The temperature increase was stopped when the temperature reached 300°C that has been set as the highest temperature Tm. After that, the temperature was maintained at 300°C. At 10 minutes after the highest temperature Tm was reached, the heating and the pressing were stopped, and the stack was then naturally cooled. In this way, an intended joined body was obtained.

### Comparative Example 2

In the section "(4) Heating and Pressing of Stack" in Example 1, the time required for the temperature to reach 300°C from 40°C was changed to 40 seconds. The temperature increase rate was changed to 6.5°C/s on average, and the pressure increase rate was changed to 1.3 MPa/s. The pressure increase was stopped when the pressure reached 20 MPa that has been set as the highest pressure Pm. After that, the pressure was maintained at the highest pressure Pm. At this time, the temperature was continuously increased. The pressure was 20 MPa when the temperature reached 200°C. The temperature increase was stopped when the temperature reached 300°C that has been set as the highest temperature Tm. After that, the temperature was maintained at 300°C. At 10 minutes after the highest temperature Tm was reached, the heating and the pressing were stopped, and the stack was then naturally cooled. In this way, an intended joined body was obtained.

### Evaluation

The outer appearance of each of the joined bodies obtained in Examples and Comparative Examples was visually observed to evaluate defects formed in the fillet portion. As a result, defects including cracks were not observed in the fillet portion of the joined body obtained in Example 1. In contrast, cracks were observed at the corners of the fillet portions of the joined bodies obtained in Comparative Examples 1 and 2.

### Industrial Applicability

According to the present invention, it is possible to provide a method for producing a joined body in which cracks formed in the fillet portion are suppressed.

## Claims

1. A method for producing a joined body in which a first joining target and a second joining target are joined with a joining layer interposed between the first joining target and the second joining target,
the method comprising:
a step of applying a paste that contains copper particles and an organic solvent to the first joining target to form a coating film;
a step of placing the second joining target on the coating film to form a stack; and
a sintering step of heating and pressing the stack to sinter the copper particles contained in the coating film to form the joining layer,
wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.

2. The method for producing a joined body according to claim 1,
wherein the coating film is applied in such a manner that the coating film has such dimensions that the coating film extends from peripheral edges of the second joining target when the second joining target is placed on the coating film.

3. The method for producing a joined body according to claim 1 or 2,
wherein, in the sintering step, control is performed in such a manner that the pressing pressure reaches the highest pressure Pm after the heating temperature reaches the highest temperature Tm.

4. The method for producing a joined body according to claim 1 or 2,
wherein the sintering step does not include a constant temperature process for 10 seconds or more from the heating start temperature to the highest temperature Tm.

5. The method for producing a joined body according to claim 1 or 2,
wherein the sintering step does not include a constant pressure process for 10 seconds or more from the pressing start pressure to the highest pressure Pm.

6. The method for producing a joined body according to claim 1 or 2,
wherein the highest temperature Tm is 200°C or more and 350°C or less.

7. The method for producing a joined body according to claim 6,
wherein, when the heating temperature reaches the highest temperature Tm, the heating temperature is kept constant within a range of (Tm - 30)°C or more and Tm°C or less.

8. The method for producing a joined body according to claim 1 or 2,
wherein the highest pressure Pm is 1 MPa or more and 40 MPa or less.

9. The method for producing a joined body according to claim 8,
wherein, when the pressing pressure reaches the highest pressure Pm, the pressing pressure is kept constant within a range of (Pm - 5) MPa or more and Pm MPa.

10. A method for joining a first joining target and a second joining target with a joining layer interposed between the first joining target and the second joining target,
the method comprising:
a step of applying a paste that contains copper particles and an organic solvent to the first joining target to form a coating film;
a step of placing the second joining target on the coating film to form a stack; and
a sintering step of heating and pressing the stack to sinter the copper particles contained in the coating film to form the joining layer,
wherein, in the sintering step, the heating is performed incrementally from a heating start temperature to a highest temperature Tm, and the pressing is performed incrementally from a pressing start pressure to a highest pressure Pm, and control is performed in such a manner that a pressing pressure is 15 MPa or less when a heating temperature reaches 200°C.
